# EUROPÄISCHE PATENTSCHRIFT

(11) **EP 3 427 999 B1**
(45) Veröffentlichungstag und Bekanntmachung des Hinweises auf die Patenterteilung: **10.04.2024**
(21) Anmeldenummer: 18020057.8
(22) Anmeldetag: 13.02.2018
(51) Int. Cl.: B60L 53/302, B60L 53/31, B60L 53/18

(54) **KÜHLEINHEIT FÜR EINE LADESÄULE UND LADESÄULE MIT EINER KÜHLEINHEIT**
COOLING UNIT FOR A STATIONARY CHARGER AND STATIONARY CHARGER WITH A COOLING UNIT
UNITÉ DE REFROIDISSEMENT POUR UNE COLONNE DE CHARGEMENT ET COLONNE DE CHARGEMENT POURVU D'UNE UNITÉ DE REFROIDISSEMENT

(30) Priorität: 12.07.2017 DE 102017115640
(43) Veröffentlichungstag der Anmeldung: 16.01.2019
(73) Patentinhaber: Dr. Ing. h.c. F. Porsche AG, 70435 Stuttgart (DE)
(72) Erfinder: Götz, Stefan, 85659 Forstern (DE); Reber, Volker, 74544 Michelbach an der Bilz (DE); Köhler, David, 74321 Bietigheim-Bissingen (DE)

(56) Entgegenhaltungen:
- EP-A1- 0 823 766
- EP-A1- 1 869 391
- EP-A1- 3 412 494
- EP-A2- 2 344 826
- EP-B1- 1 869 391
- EP-B1- 2 344 826
- DE-A1-102012 104 520
- DE-A1-102015 105 921
- DE-A1-102015 112 347
- DE-A1-102015 120 048
- US-A- 5 591 937

## Beschreibung

Die vorliegende Erfindung betrifft eine Stromtankstelle umfassend mehrere Ladesäulen,
wobei mindestens eine Ladesäule eine Kühleinrichtung und ein Ladekabel mit einem geschlossenen Sekundärkühlmittelkreislauf aufweist und
wobei die Stromtankstelle einen gemeinsamen Primärkühlmittelkreislauf mehrerer Ladesäulen aufweist.

### Stand der Technik

Als Ladestation wird in der Elektrotechnik jedwede stationäre Vorrichtung oder elektrische Anlage bezeichnet, welche dazu dient, mobilen akkubetriebenen Geräten, Maschinen oder Kraftfahrzeugen durch einfaches Einstellen oder Einstecken Energie zuzuführen, ohne den Energiespeicher - etwa die Traktionsbatterie eines Elektroautos - entnehmen zu müssen. Ladestationen für Elektroautos werden umgangssprachlich auch als "Stromtankstellen" bezeichnet und können mehrere Ladepunkte umfassen, die je nach Bauform als "Ladesäulen" charakterisiert werden.

Bekannt sind hier insbesondere Gleichstrom-Schnellladesysteme (*high performance charging,* HPC) wie das in Europa verbreitete sogenannte kombinierte Ladesystem (*combined charging* system, CCS). Beim gattungsmäßigen Gleichstromladen wird Gleichstrom aus der Ladesäule direkt in das Fahrzeug eingespeist und hierzu durch einen leistungsstarken Gleichrichter vom Stromnetz oder durch große Pufferakkumulatoren an Solartankstellen bereitgestellt. Im Fahrzeug befindet sich ein Batteriemanagementsystem, das mit der Ladesäule kommuniziert, um die Stromstärke anzupassen oder bei Erreichung einer Kapazitätsgrenze den Vorgang zu beenden.

Die hierzu erforderliche Leistungselektronik ist nach dem Stand der Technik üblicherweise in der Ladesäule integriert und bis zu einer Leistungsgrenze von 50 kW belastbar. Da die Gleichstromanschlüsse der Ladesäule direkt mit entsprechenden Anschlüssen der Traktionsbatterie verbunden werden, lassen sich so verlustarm hohe Ladeströme übertragen, was kurze Ladezeiten ermöglicht, jedoch auch zu einer Wärmeentwicklung führt.

Um das Gewicht und die Flexibilität des Ladekabels für den Nutzer gering zu halten, sind in der Literatur Kabelkühlsysteme mit flüssigkeitsdurchflossenen Ladekabeln beschrieben. CN 206225028, DE 102011100389, US 2012043935, US 2015217654, DE102015112347 A1 sowie US 2017028862 offenbaren exemplarisch derartige Ladekabel, in deren Kabelmantel ein Kühlfluid fließt.

Die nachveröffentlichte Druckschrift EP3412494 offenbart eine Stromtankstelle mit lediglich einer gattungsgemäßen Ladesäule.

Solche Systeme weisen jedoch Probleme bei der Installation, der Inbetriebnahme und der Wartung auf. Insbesondere das Ladekabel ist besonders hohem Verschleiß durch den regelmäßigen Einsatz, Witterung oder unsachgemäße Handhabung ausgesetzt. Der Austausch und die Installation benötigen jedoch in der Regel die Montage der Komponenten des Kühlsystems bzw. den Anschluss des Kabelkühlkreislaufes an das Kühlsystem der Ladesäule. Zu diesem Zweck ist einerseits Kühlflüssigkeit einzufüllen und zusätzlich der Kühlkreislauf für einen problemlosen Betrieb zu entlüften. Diese Tätigkeiten sind zeitaufwändig, fehleranfällig und binden Wartungsteams vor Ort an den Ladesäulen. Alternativen mit Leckage- oder gar totvolumenfreien Steckverbindern, die eine Befüllung oder Entlüften vermeiden könnten, sind unverhältnismäßig teuer und empfindlich.

### Offenbarung der Erfindung

Die Erfindung stellt eine eine Stromtankstelle gemäß dem unabhängigen Anspruch bereit.

Ein Vorzug dieser Lösung liegt in der Schaffung eines austauschbaren Kühlsystems. Das Kühlsystem kann so bereits gefüllt angeliefert und montiert, eine Entlüftung des Kühlkreislaufes vor Ort vermieden werden.

Der Kühlkreislauf des Ladekabels wird hierzu über einen Wärmetauscher an den Flüssigkühlkreis der Ladesäule angeschlossen, der ein anderes Kühlmedium verwenden kann. Sämtliche Verschlüsse und Kupplungen erlauben eine Schnellmontage.

Die Kühleinheit befindet sich vorzugsweise an einem hohen Punkt in der Ladesäule. Das Kabel mitsamt Kühleinheit lässt sich bei der Montage vor Ort so von oben in die Ladesäule hineinsenken.

Die Fixierung des Ladekabels erfolgt lediglich durch einige Fixierungen des Mantels (klemmend, an Austritt aus Ladesäule und ggf. in Tragarm der Säule) und durch Fixierung oder Aufhängung der Kühleinheit im Inneren der Ladesäule. Die Einheit und die Ladesäule sind damit so gestaltet, dass das Kabel ohne weitere komplizierte Montageschritte im Schnellverfahren platziert und montiert werden kann.

Weitere vorteilhafte Ausgestaltungen der Erfindung sind in den abhängigen Patentansprüchen angegeben.

### Kurze Beschreibung der Zeichnungen

Ein Ausführungsbeispiel der Erfindung ist in den Zeichnungen dargestellt und wird im Folgenden näher beschrieben.
Figur 1 zeigt die perspektivische Ansicht einer ersten Ladesäule.
Figur 2 zeigt die Explosionsdarstellung einer zweiten Ladesäule.
Figur 3 zeigt die perspektivische Ansicht einer Kühleinheit der zweiten Ladesäule.
Ausführungsformen der Erfindung

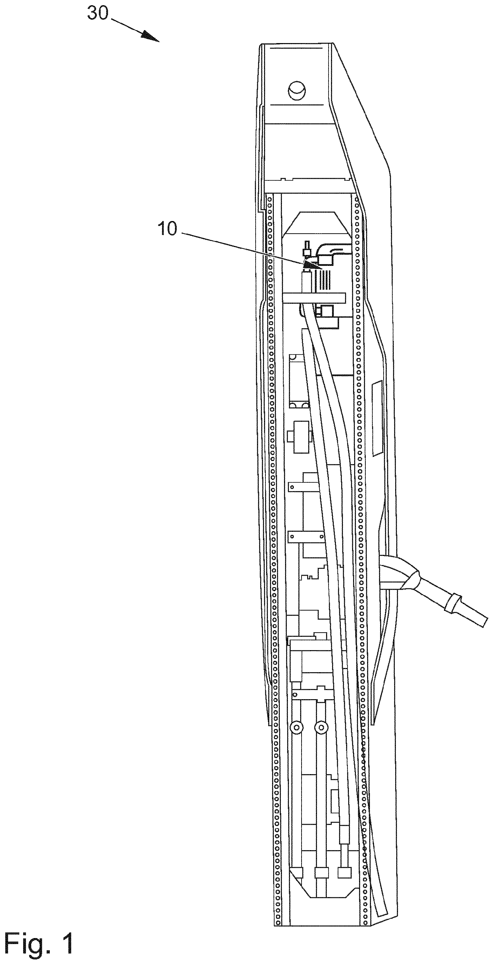

Figur 1 illustriert den grundlegenden Aufbau der vorgeschlagenen Ladesäule (30) zur Verwendung in einer Stromtankstelle gemäß der Erfindung. Als erfindungswesentliches Merkmal umfasst die Ladesäule (30) eine Kühleinheit (10), die den geschlossenen Sekundärkühlmittelkreislauf der Ladesäule (30) abkühlt, wenn die Ladesäule (30) fluidtechnisch mit dem gemeinsamen Primärkühlmittelkreislauf mehrerer Ladesäulen einer Stromtankstelle verbunden wird.

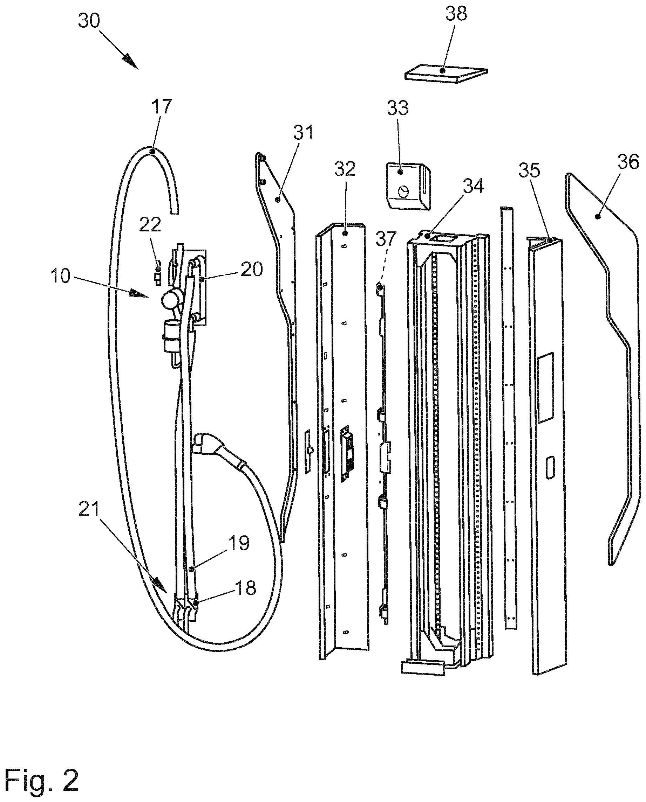

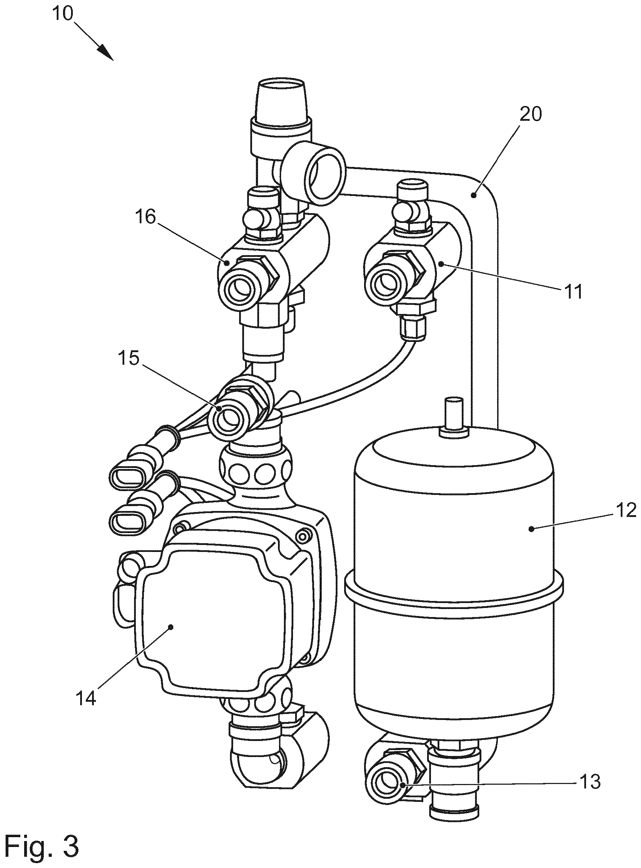

Eine Zusammenschau der geringfügig abweichenden Ausführungsform gemäß Figur 2 mit dessen in Figur 3 detailliert dargestellter Kühleinheit (10) verdeutlicht dieses Wirkprinzip: Die Kühleinheit (10) basiert demnach auf einem Wärmetauscher (20) mit ersten Anschlüssen (11, 13) und zweiten Anschlüssen (15, 16). Während die ersten Anschlüsse (11, 13) - über zwei Schläuche (19) mit Absperrhähnen (18) - mit den Anschlusspunkten (21) des Primärkühlmittelkreislaufes verbunden sind, speisen die zweiten Anschlüsse (15, 16) über eine Pumpe (14) mit Ausgleichsbehälter (12) den Sekundärkühlmittelkreislauf, dessen Wärme über den Wärmetauscher (20) auf den Primärkühlmittelkreislauf übertragen werden soll. Während der Primärkühlmittelkreislauf typischerweise ein Wasser-Glykol-Gemisch führt, kann der Sekundärkühlmittelkreislauf so mit einem synthetischen, beispielsweise unter dem Handelsnamen "Novec" vertriebenen Methoxyhepta- oder -nonafluorpropan, Hydrofluorether, Fluoroketon oder anderweitigem nichtleitenden und möglichst reaktionsträgen Fluid befüllt werden.

Die solchermaßen vorkonfektionierte Kühleinheit (10) lässt sich montagefreundlich in das in Figur 2 dargestellte Innengerüst (34) der Ladesäule (30) absenken, dessen Gehäuse von Außenwänden (32, 35) mit äußerlich anliegenden Auslegerplatten (31, 36) aus Harzmatte (*sheet molding compound,* SMC) gebildet und vorliegend über einen Schließmechanismus (37) der linken Außenwand (32) zugänglich ist. Formschlüssig zwischen den abbildungsgemäß oberen Enden der Auslegerplatten (31, 36) sind ein oberer Kabelhalter (33) und ein Dach (38) mit Tropfkante angeordnet. Der Kabelhalter (33) wiederum setzt sich aus zwei Spritzgussteilen zusammen, welche durch zwei komplementär geformten Aussparungen das gekühlte Ladekabel (17) zwischen sich aufnehmen.

## Patentansprüche

1. Stromtankstelle umfassend einen Primärkühlmittelkreislauf, genannt gemeinsamer Primärkühlmittelkreislauf, des Weiteren mit folgenden Merkmalen:
- die Stromtankstelle umfasst eine Ladesäule (30),
- die Ladesäule (30) umfasst eine Kühleinheit (10) und ein Ladekabel (17) mit einem geschlossenen Sekundärkühlmittelkreislauf,
- die Ladesäule (30) umfasst Schläuche (19) zum Verbinden mit dem gemeinsamen Primärkühlmittelkreislauf der Stromtankstelle,
- die Kühleinheit (10) umfasst einen Wärmetauscher (20) mit ersten Anschlüssen (11, 13) und zweiten Anschlüssen (15, 16),
- die ersten Anschlüsse (11, 13) der Kühleinheit (10) sind mit den Schläuchen (19) fluidtechnisch verbunden,
- die zweiten Anschlüsse (15, 16) sind mit dem Sekundärkühlmittelkreislauf fluidtechnisch verbunden und
- die Kühleinheit (10) ist dazu eingerichtet, den Sekundärkühlmittelkreislauf abzukühlen, wenn die ersten Anschlüsse (11, 13) mit dem Primärkühlmittelkreislauf fluidtechnisch verbunden sind,
mit dem folgenden weiteren **Merkmal:**
- die Stromtankstelle umfasst weitere Ladesäulen, die fluidtechnisch mit dem gemeinsamen Primärkühlmittelkreislauf der Stromtankstelle verbunden sind.

2. Stromtankstelle nach Anspruch 1,
**gekennzeichnet durch** folgende Merkmale:
- die Kühleinheit (10) umfasst eine Pumpe (14) und
- die Pumpe (14) ist mit den zweiten Anschlüssen (15, 16) fluidtechnisch verbunden.

3. Stromtankstelle nach Anspruch 2,
**gekennzeichnet durch** folgende Merkmale:
- die Kühleinheit (10) umfasst einen Ausgleichsbehälter (12) und
- der Ausgleichsbehälter (12) ist mit der Pumpe (14) fluidtechnisch verbunden.

4. Stromtankstelle nach einem der Ansprüche 1 bis 3,
**gekennzeichnet durch** folgendes Merkmal:
- der Sekundärmittelkreislauf ist mit einem reaktionsträgen, vorzugsweise inerten nichtleitenden Fluid, insbesondere Methoxyheptafluorpropan, Methoxynonafluorpropan, Hydrofluorether oder Fluoroketon gefüllt.

5. Stromtankstelle nach einem der Ansprüche 1 bis 4,
**gekennzeichnet durch** folgende Merkmale:
- die Schläuche (19) weisen Absperrhähne (18) und Anschlusspunkte (21) zum Anschließen des Primärkühlmittelkreislaufes auf und
- die Absperrhähne (18) sind an den Anschlusspunkten (21) angeordnet.

6. Stromtankstelle nach einem der Ansprüche 1 bis 5,
**gekennzeichnet durch** folgende Merkmale:
die eine Ladesäule (30) umfasst eine linke Außenwand (32) mit einer linken Auslegerplatte (31), vorzugsweise einer Harzmatte, eine rechte Außenwand (35) mit einer rechten Auslegerplatte (36) und ein vorzugsweise mit einer Tropfkante versehenes Dach (38),
- die Auslegerplatten (31, 36) liegen äußerlich an den Außenwänden (32, 35) an und
- das Dach (38) ist formschlüssig zwischen den Auslegerplatten (31, 36) angeordnet.

7. Stromtankstelle nach Anspruch 6,
**gekennzeichnet durch** folgende Merkmale:
_ die eine Ladesäule (30) umfasst einen aus zwei Spritzgussteilen bestehenden Kabelhalter (33) und
- der Kabelhalter (33) ist ebenfalls formschlüssig zwischen den Auslegerplatten (31, 36) angeordnet und vom Dach (38) bedeckt.

8. Stromtankstelle nach Anspruch 6 oder 7,
**gekennzeichnet durch** folgende Merkmale:
- eine der Außenwände (32, 35) der einen Ladesäule weist einen Schließmechanismus (37) auf.

## Claims

1. An electric filling station comprising a primary coolant circuit, called a common primary coolant circuit, further having the following features:
- the electric filling station comprises a charging column (30),
- the charging column (30) comprises a cooling unit (10) and a charging cable (17) having a closed secondary coolant circuit,
- the charging column (30) comprises hoses (19) for connecting to the common primary coolant circuit of the electric filling station,
- the cooling unit (10) comprises a heat exchanger (20) having first connections (11, 13) and second connections (15, 16),
- the first connections (11, 13) of the cooling unit (10) are fluidically connected to the hoses (19),
- the second connections (15, 16) are fluidically connected to the secondary coolant circuit, and
- the cooling unit (10) is configured to cool the secondary coolant circuit when the first connections (11, 13) are fluidically connected to the primary coolant circuit,
having the following further feature:
- the electric filling station comprises further charging columns which are fluidically connected to the common primary coolant circuit of the electric filling station.

2. The electric filling station'according to claim 1,
**characterised by** the following features:
- the cooling unit (10) comprises a pump (14), and
- the pump (14) is fluidically connected to the second connections (15, 16).

3. The electric filling station according to claim 2,
**characterised by** the following features:
- the cooling unit (10) comprises a compensation vessel (12), and
- the compensation vessel (12) is fluidically connected to the pump (14).

4. The electric filling station according to any one of claims 1 to 3,
**characterised by** the following feature:
- the secondary coolant circuit is filled with chemically unreactive, preferably inert, non-conductive fluid, in particular methoxyheptafluoropropane, methoxynonafluoropropane, hydrofluoroether or fluoroketone.

5. The electric filling station according to any one of claims 1 to 4,
**characterised by** the following features:
- the hoses (19) have shut-off valves (18) and connection points (21) for connecting the primary coolant circuit, and
- the shut-off valves (18) are arranged at the connection points (21).

6. The electric filling station according to any one of claims 1 to 5,
**characterised by** the following features:
- the one charging column (30) comprises a left-hand outer wall (32) having a left-hand bracket plate (31), preferably a resin mat, a right-hand outer wall (35) having a right-hand bracket plate (36), and a roof (38) that is preferably provided with a drip edge,
- the bracket plates (31, 36) abut the outer walls (32, 35) externally, and
- the roof (38) is arranged in 'a form-fitting manner between the bracket plates (31, 36).

7. The electric filling station according to claim 6,
**characterised by** the following features:
- the one charging column (30) comprises a cable holder (33) consisting of two injection molded parts and the cable holder (33) is also arranged in a form-fitting manner between the bracket plates (31, 36) and is covered by the roof (38).

8. The electric filling station according to claim 6 or 7,
**characterised by** the following features:
- one of the outer walls (32, 35) of the one charging column comprises a closing mechanism (37).

## Revendications

1. Station de remplissage électrique comprenant un circuit primaire de refroidissement, appelé circuit primaire de refroidissement commun, ayant en outre les caractéristiques suivantes :
- la station de remplissage électrique comprend une colonne de charge (30),
- la colonne de charge (30) comprend une unité de refroidissement (10) et un câble de charge (17) ayant un circuit de refroidissement secondaire fermé,
- la colonne de charge (30) comprend des tuyaux (19) pour le raccordement au circuit de refroidissement primaire commun de la station de remplissage électrique,
- l'unité de refroidissement (10) comprend un échangeur de chaleur (20) ayant des premiers raccords (11, 13) et des deuxièmes raccords (15, 16),
- les premiers raccords (11, 13) de l'unité de refroidissement (10) sont raccordés fluidiquement aux tuyaux (19),
- les deuxièmes raccords (15, 16) sont raccordés fluidiquement au circuit de refroidissement secondaire, et
- l'unité de refroidissement (10) est configurée pour refroidir le circuit de refroidissement secondaire lorsque les premiers raccords (11, 13) sont raccordés fluidiquement au circuit de refroidissement primaire,
ayant la caractéristique supplémentaire suivante :
- la station de remplissage électrique comprend d'autres colonnes de charge qui sont raccordées fluidiquement au circuit de refroidissement primaire commun de la station de remplissage électrique.

2. Station de remplissage électrique selon la revendication 1,
**caractérisée par** les caractéristiques suivantes :
- l'unité de refroidissement (10) comprend une pompe (14), et
- la pompe (14) est raccordée fluidiquement aux deuxièmes raccords (15, 16).

3. Station de remplissage électrique selon la revendication 2,
**caractérisée par** les caractéristiques suivantes :
- l'unité de refroidissement (10) comprend une cuve de compensation (12), et
- la cuve de compensation (12) est raccordée fluidiquement à la pompe (14).

4. Station de remplissage électrique selon l'une quelconque des revendications 1 à 3,
**caractérisée par** la caractéristique suivante :
- le circuit de refroidissement secondaire est rempli d'un fluide chimiquement non réactif, de préférence inerte, non conducteur, en particulier du méthoxyheptafluoropropane, du méthoxynonafluoropropane, de l'hydrofluoroéther ou de la fluorocétone.

5. Station de remplissage électrique selon l'une quelconque des revendications 1 à 4,
**caractérisée par** les caractéristiques suivantes :
- les tuyaux (19) ont des vannes d'arrêt (18) et des points de raccord (21) pour raccorder le circuit de refroidissement primaire, et
- les vannes d'arrêt (18) sont agencées au niveau des points de raccord (21).

6. Station de remplissage électrique selon l'une quelconque des revendications 1 à 5,
**caractérisée par** les caractéristiques suivantes :
- la colonne de charge (30) comprend une paroi extérieure gauche (32) ayant une plaque de support gauche (31), de préférence un tapis de résine, une paroi extérieure droite (35) ayant une plaque de support droite (36), et un toit (38) qui est de préférence muni d'un bord d'égouttage,
- les plaques de support (31, 36) viennent en butée contre les parois extérieures (32, 35) de manière externe, et
- le toit (38) est agencé par liaison de forme entre les plaques de support (31, 36).

7. Station de remplissage électrique selon la revendication 6,
**caractérisée par** les caractéristiques suivantes :
- la colonne de charge (30) comprend un porte-câble (33) constitué de deux parties moulées par injection et le porte-câble (33) est également agencé par liaison de forme entre les plaques de support (31, 36) et est recouvert par le toit (38).

8. Station de remplissage électrique selon la revendication 6 ou 7,
**caractérisée par** les caractéristiques suivantes :
- une des parois extérieures (32, 35) de la colonne de charge comprend un mécanisme de fermeture (37).
